# EUROPÄISCHE PATENTSCHRIFT

(11) **EP 0 838 083 B1**
(45) Veröffentlichungstag und Bekanntmachung des Hinweises auf die Patenterteilung: **03.07.2002**
(21) Anmeldenummer: 96908907.7
(22) Anmeldetag: 01.04.1996
(51) Int. Cl.: H01L 21/00

(54) **TRÄGER FÜR SCHEIBENFÖRMIGE GEGENSTÄNDE, INSBESONDERE SILIZIUMSCHEIBEN**
SUPPORT FOR WAFER-SHAPED OBJECTS, IN PARTICULAR SILICON WAFERS
SUPPORT POUR OBJETS EN FORME DE PASTILLE, EN PARTICULIER DES PASTILLES DE SILICIUM

(30) Priorität: 12.07.1995 AT 118895; 15.02.1996 WO PCT/AT96/00024
(43) Veröffentlichungstag der Anmeldung: 29.04.1998
(73) Patentinhaber: SEZ Semiconductor-Equipment Zubehör für die Halbleiterfertigung AG, 9500 Villach (AT)
(72) Erfinder: SUMNITSCH, Franz, A-9020 Klagenfurt (AT)
(74) Vertreter: Beer, Manfred, Dipl.-Ing.
(86) Internationale Anmeldenummer: AT9600063
(87) Internationale Veröffentlichungsnummer: WO9703457

(56) Entgegenhaltungen:
- EP-A- 0 467 623
- DE-A- 3 522 465
- US-A- 5 421 595

## Beschreibung

Die Erfindung betrifft einen Träger für scheibenförmige Gegenstände, insbesondere für Siliziumscheiben, den Merkmalen des einleitenden Teils von Anspruch 1.

Ein derartiger Träger ist aus der US-A-5 421 595 bekannt. Bei dem aus der US-A-5 421 595 bekannten Träger sind die mit Unterdruck beaufschlagten Öffnungen in der dem scheibenförmigen Gegenstand zugekehrten Fläche des Trägers durch eine Platte aus porösem Werkstoff abgedeckt. In der dem Gegenstand zugekehrten Fläche des Trägers sind keine Vorsprünge vorgesehen. Vielmehr ist diese Fläche völlig eben ausgebildet.

Aus der EP-A-0 467 623 ist ein Träger für Siliziumscheiben bekannt, der diese während der Gasphasenabscheidung halten soll, ohne die Siliziumscheiben in Drehung zu versetzen. Dieser bekannte Träger besitzt eine Ringdüse für austretendes Gas und innerhalb der Ringdüse ein Netz aus beaufschlagten, radial verlaufenden und kreisförmigen Nuten, die von einer einzigen zentralen Öffnung mit Unterdruck beaufschlagt werden.

Aus der DE-A-3 522 465 ist eine Halterung für Siliziumscheiben bekannt, deren Zweck es ist, während der chemischen Behandlung von Siliziumscheiben eine Oberfläche derselben vor dem Behandlungsmedium zu schützen. Hiezu besitzt die bekannte Vorrichtung ein tellerförmiges Element, in dessen Mitte ein rohrförmiger Träger vorgesehen ist, der hohl ausgebildet ist und in seiner Stirnfläche, an der die Siliziumscheibe anliegt, eine mit Unterdruck beaufschlagte Öffnung aufweist. Zum Abdichten ist in einer Nut in der Stirnfläche eine Ringdichtung eingelegt. Das vor dem Teller liegende Ende des Trägers weist mehrere radial nach außen weisende Öffnungen auf, durch die ein Spülmedium austreten kann, um die Unterseite der Siliziumscheibe zu spülen, so daß Behandlungsmedium nicht auf diese gelangen kann.

Der Erfindung liegt die Aufgabe zugrunde, den aus der US-A-5 421 595 bekannten Träger so zu verbessern, daß ein sicheres Halten von scheibenförmigen Gegenständen möglich ist, während sie mit Behandlungsflüssigkeit behandelt werden.

Erfindungsgemäß wird diese Aufgabe durch die in Anspruch 1 genannten Merkmale gelöst.

Bei dem erfindungsgemäßen Träger wird der scheibenförmige Gegenstand in Anlage an die ringförmigen Rippen der ihm zugekehrten Fläche des Trägers gezogen. Da die Rippen bei der Erfindung am scheibenförmigen Gegenstand außerhalb dessen Mitte anliegen, wird der Gegenstand während des Behandelns sicher gehalten (keine Gefahr des Kippens) und der Gegenstand kann durch Drehen des Trägers in Drehung versetzt werden. Da die Rippen am Gegenstand außermittig angreifen, können vom Träger auf den scheibenförmigen Gegenstand Drehmomente übertragen werden. Durch die besondere Anordnung der mit Unterdruck beaufschlagten Öffnungen in der dem scheibenförmigen Gegenstand zugewendeten Fläche des Trägers wird ein hinreichender Anlagedruck zwischen den Rippen und dem Gegenstand erreicht. Überdies ergibt sich der Vorteil, daß Behandlungsmedium im Falle eines Bruches des scheibenförmigen Gegenstandes vom Träger abgesaugt wird und nicht in nachgeordnete Anlagenteile gelangen kann.

Da bei der Erfindung vorgesehen ist, daß innerhalb der äußersten ringförmigen Rippe mit Unterdruck beaufschlagte Öffnungen vorgesehen sind, und daß jede ringförmige Rippe mit Ausnahme der äußersten Rippe wenigstens einmal unterbrochen ist, können die mit Unterdruck beaufschlagten Öffnungen an irgendeiner Stelle innerhalb der äußersten ringförmigen Rippe, also auch innerhalb der innersten ringförmigen Rippe oder zwischen einander benachbarten ringförmigen Rippen angeordnet sein.

Die ringförmigen Rippen an der dem scheibenförmigen Gegenstand zugekehrten Fläche des Trägers sind mit dem innerhalb der ringförmigen Düse liegenden Teil des Trägers, vorzugsweise einstückig ausgebildet und stehen über die dem scheibenförmigen Gegenstand zugekehrte Fläche des Trägers vor.

In einer räumlich besonders günstigen Ausführungsform kann vorgesehen sein, daß die ringförmigen Rippen konzentrisch zur Achse des Trägers angeordnet sind.

Bei dem erfindungsgemäßen Träger geht von den mit Unterdruck beaufschlagten Öffnungen je eine Leitung aus, die zu einer Unterdruck erzeugenden Einrichtung führt, so daß es besonders einfach möglich ist, die innerhalb der ringförmigen Rippen vorgesehenen Öffnungen mit Unterdruck zu beaufschlagen. Dabei ist gemäß der Erfindung vorgesehen, daß die Unterdruck erzeugenden Einrichtungen Injektordüsen sind. Dies ergibt den Vorteil, daß die den Unterdruck erzeugenden Einrichtungen durch das der Ringdüse des Trägers zugeführte Druckgas betrieben werden, indem die Injektordüsen vom die ringförmige Düse beaufschlagenden Druckgas durchströmt werden. Bei dieser Ausführungsform sind mechanische, sich bewegende Bauteile entbehrlich, so daß sich eine robuste und dennoch funktionssichere Konstruktion ergibt.

Eine räumlich besonders günstige Anordnung ergibt sich, weil die Unterdruck erzeugende Einrichtung im Träger angeordnet ist.

Weitere Einzelheiten und Vorteile der Erfindung ergeben sich aus der nachstehenden Beschreibung der in der Zeichnungen dargestellten Ausführungsformen von Trägern der Erfindung.

Es zeigt:
- Fig. 1: einen Träger teilweise geschnitten,
- Fig. 2: eine Einzelheit von Fig. 1,
- Fig. 3: eine weitere Ausführungsform im Axialschnitt und
- Fig. 4: eine Draufsicht auf den Träger aus Fig. 3.

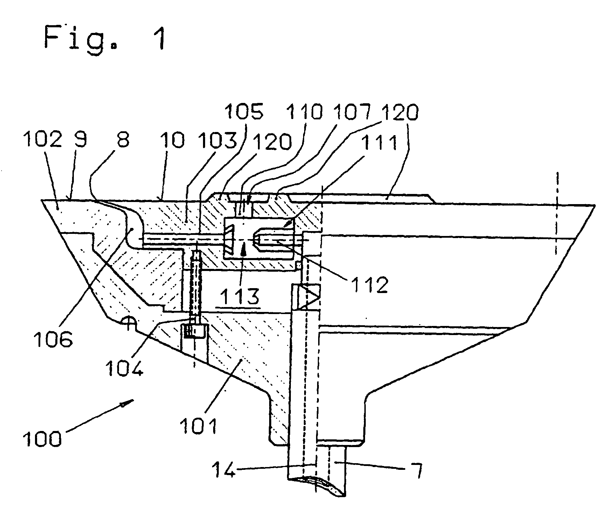

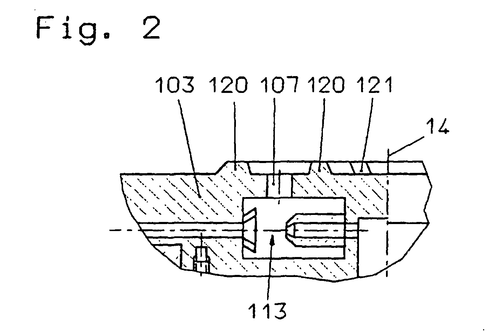

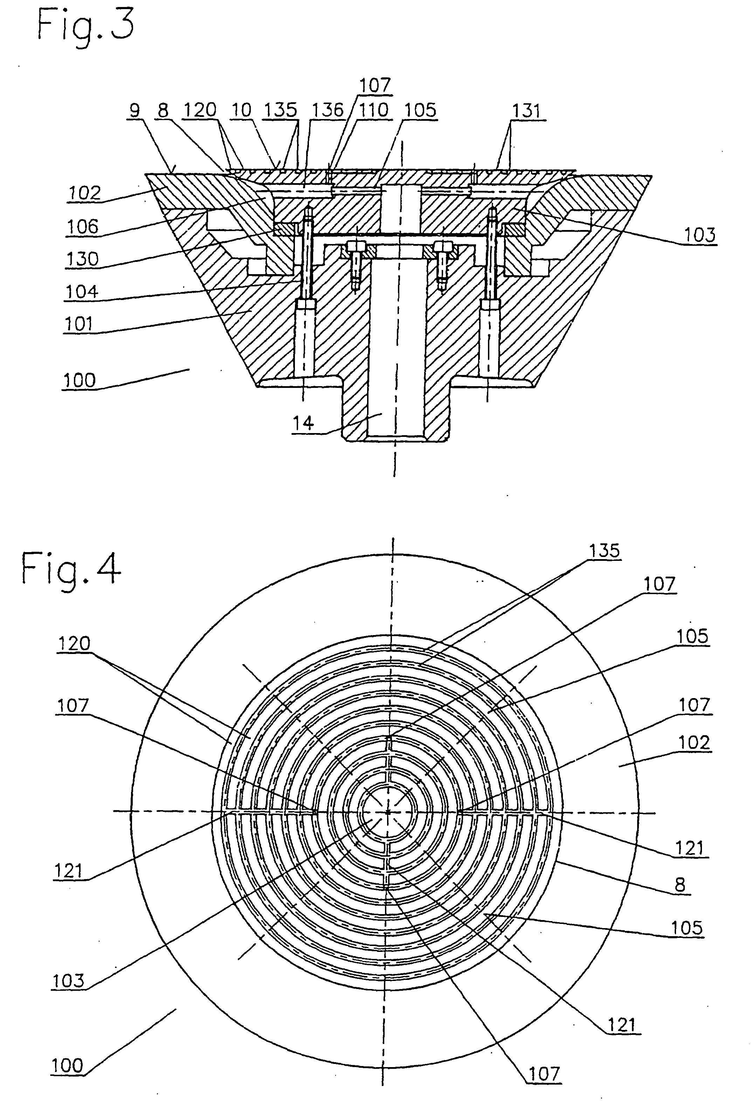

Bei der in der Fig. 1 und 2 gezeigten Ausführungsform besteht der Träger 100 aus mehreren rotationssymmetrischen Teilen, nämlich einem unteren topfförmigen Teil 101, einem ringförmigen Teil 102 und einem plattenförmigen, runden Teil 103, der mit Hilfe von Schrauben 104 am topfförmigen Teil 101 befestigt ist und dabei den ringförmigen Teil 102 festlegt. Zwischen dem ringförmigen Teil 102 und dem mittleren, kreisrunden, plattenförmigen Teil 103 ist eine ringförmige Düse 8 für den Austritt von Gas vorgesehen, das über einen Kanal 14 in der Welle 7 und mehrere radiale Bohrungen 105 in einen Raum 106 zwischen dem ringförmigen Teil 102 und dem kreisrunden, plattenförmigen Teil 103 zugeführt wird. Die lichte Weite der ringförmigen Düse 8 kann durch einen zwischen die Teile 102 und 103 eingelegten Distanzring 130 (vgl. Fig. 3) eingestellt werden.

Wie in Fig. 1 gezeigt, schließen die von den Teilen 102 und 103 gebildete Begrenzungswände der Düse 8 mit der oberen Fläche des Trägers 100 einen spitzen Winkel ein.

Die obere, einem zu haltenden Gegenstand zugekehrte Fläche des Trägers 100 wird von einer Kreisringfläche 9 des Teils 102 und einer Kreisfläche 10 des Teils 103 gebildet. Zwischen der Kreisringfläche 9 und der Kreisfläche 10 mündet die ringförmige Düse 8 aus.

Bei dem erfindungsgemäß ausgebildeten Träger 100 ist es für das sichere Festhalten eines scheibenförmigen Gegenstandes nicht mehr wesentlich, daß durch die besondere Ausbildung der ringförmigen Düse 8 beim Ausströmen von Gas aus der Düse 8 zwischen der dem Gegenstand zugekehrten Fläche des Trägers 100 und dem Gegenstand ein Unterdruck entsteht, der den scheibenförmigen Gegenstand in Anlage an die ringförmigen Rippen 120 hält. Ein nach dem Bernoulli-Prinzip allenfalls entstehende Unterdruck kann aber das Festhalten des Gegenstandes unterstützen. Bei der Erfindung sorgt das aus der ringförmigen Düse 8 ausströmende Druckgas in erster Linie dafür, daß Behandlungsflüssigkeit nicht auf die Unterseite des scheibenförmigen Gegenstandes gelangen und am Träger 100 Korrosion verursachen kann. Zusätzlich unterstützt das aus der ringförmigen Düse 8 ausströmende Druckgas das Abschleudern von Behandlungsmedium, indem es vom Umfang des scheibenförmigen Gegenstandes abgeschleuderte Tropfen des Behandlungsmediums wegbläst.

Bei der in Fig. 1 gezeigten Ausführungsform des Trägers 100 sind die ringförmigen Rippen 120 mit dem Teil 103 einstückig ausgebildet und zur Achse des Trägers 100 koaxial und zueinander konzentrisch angeordnet.

Um im Bereich innerhalb der äußersten Rippe 120 Unterdruck zu erzeugen, sind beim erfindungsgemäßen Träger 100 in der dem scheibenförmigen Gegenstand zugekehrten Fläche 10 des Teils 103 Öffnungen 107 vorgesehen, die mit Unterdruck beaufschlagt werden.

Von den Öffnungen 107 gehen Leitungen 110 aus, die zu Unterdruck erzeugenden Einrichtungen 111 führen, die im Teil 103 des Trägers 100 untergebracht sind. Die Unterdruck erzeugenden Einrichtungen 111 umfassen eine Injektordüse 112, die in einer Kammer 113 vorgesehen ist, die im Teil 103 des Trägers 100 ausgespart ist. Die Injektordüse 112 wird von dem durch den Kanal 14 zugeführten Druckgas beaufschlagt, sodaß im Raum 113 Unterdruck entsteht, der sich durch die Leitung 110 zur Öffnung 107 fortpflanzt. Das aus der Injektordüse 112 austretende Druckgas strömt dann in (wenigstens) eine radiale Bohrung 105, in den Raum 106 und aus diesem über die ringförmige Düse 8 ab.

In jeder der ringförmigen Rippen 120 mit Ausnahme der äußersten ringförmigen Rippe 120 sind radial ausgerichtete Unterbrechungen 121 (Fig. 2)vorgesehen. Diese radial ausgerichteten Unterbrechungen - im einfachsten Fall eine radiale Nut 121 - sorgen dafür, daß sich der über die an einer beliebigen Stelle innerhalb der äußersten ringförmigen Rippe 120 angeordnete Öffnung 107 angelegte Unterdruck über den gesamten Bereich innerhalb der äußersten ringförmigen Rippe 120 ausbreiten kann.

Die mit Unterdruck beaufschlagten Öffnungen 107 ergeben den Vorteil, daß, und dies ist insbesondere beim Ätzen von Siliziumscheiben mit sauren Behandlungsmedien von Bedeutung, im Falle des Bruches eines scheibenförmigen Gegenstandes Behandlungsmedium, das innerhalb der ringförmigen Vorsprünge 120 auf den Teil 103 des Trägers 100 gelangt, durch die Öffnungen 107 abgesaugt wird, so daß weitere Beschädigungen vermieden sind.

In der in Fig. 3 und 4 gezeigten Ausführungsform besteht der Träger 100 aus drei rotationssymmetrischen Teilen, nämlich dem unteren, topfförmigen Teil 101, dem ringförmigen Teil 102 und dem plattenförmigen Teil 103, der mit Schrauben 104 am topfförmigen Teil 101 befestigt ist, wobei er unter Zwischenfügung eines Distanzringes 130, der zur Einstellung der Düse 8 dient, den ringförmigen Teil 102 gegen den topfförmigen Teil 101 niederspannt.

Zwischen der dem (nicht gezeigten) Gegenstand, z.B. einem Siliziumwafer, zugekehrten Ringfläche 9 des ringförmigen Teils 102 und der dem Gegenstand zugekehrten Fläche 10 des Teils 103 ist eine ringförmige Düse 8 für den Austritt von Gas vorgesehen, das unter Druck über mehrere Kanäle 105, die sich radial erstrecken, zur ringförmigen Düse 8 strömt.

Wie aus Fig. 3 ersichtlich, wird die dem Gegenstand zugekehrte Fläche 10 des Teils 103 des Trägers 100 von den Ringflächen 131 ringförmiger Rippen 120 gebildet, die über die Fläche 10 des Teils 103 gleichmäßig verteilt angeordnet sind. Sämtliche ringförmigen Rippen 120 sind gleich breit ausgebildet und voneinander durch ebenfalls gleich breit ausgebildete Rillen 135 getrennt.

Von durchmesservergrößerten Abschnitten 136 einzelner Kanäle 105 führen Leitungen 110, die parallel zur Achse des Trägers 100 ausgerichtet sind, zu Öffnungen 107, die wegen der injektordüsenartigen Wirkung der durchmesservergrößerten Abschnitte 136 der Kanäle 105 mit Unterdruck beaufschlagt sind, wenn Druckgas aus dem Kanal 14 zur ringförmigen Düse 8 strömt.

Im Ausführungsbeispiel von Fig. 4 sind vier Öffnungen 107 vorgesehen, die gleichmäßig auf einen Kreis verteilt angeordnet sind, dessen Radius kleiner ist als die Hälfte des größten Radius des Teils 103, nämlich des Radius des Umfangrandes derselben, der die ringförmigen Düse 8 nach innen begrenzt.

Um den über die Öffnung 107 angelegten Unterdruck in alle außerhalb der Öffnungen 107 zwischen ringförmigen Rippen 120 angeordneten Nuten 135 zu verteilen, sind die ringförmigen Rippen 120 je zweimal mit Unterbrechungen 121 versehen, wobei die Unterbrechungen 121 auf Radiallinien liegen. Sinngemäß sind die innerhalb der Öffnungen 107 liegenden ringförmigen Rippen 120 durch Unterbrechungen 121 zweimal unterbrochen, so daß auch die zwischen diesen liegenden Rillen 135 mit Unterdruck beaufschlagt werden.

Durch den von den injektordüsenartig wirkenden Abschnitten 136 der Kanäle 105 erzeugten und durch die Öffnungen 107 in alle Rillen 135 weitergeleiteten Unterdruck wird ein scheibenförmiger Gegenstand über den gesamten Bereich der Fläche 10 des Teils 103 des Trägers 100 gleichmäßig an die Ringflächen 131 der ringförmigen Rippen 120 angesaugt, so daß er sicher festgehalten ist.

Radial verlaufenden Kanäle 105, die ohne als Injektordüsen wirkende, durchmesservergrößerte Abschnitte 136 ausgebildet sind, können zusätzlich vorgesehen sein und verlaufen vorzugsweise zu den mit durchmesservergrößerten Abschnitten 136 ausgerüsteten Kanälen 105 versetzt und sind beispielsweise jeweils in der Mitte zwischen zwei solchen Kanälen 105 angeordnet. Dadurch wird die ringförmige Düse 8 besonders gleichmäßig mit über den Kanal 14 zugeführtem Druckgas beaufschlagt.

Auch bei der in Fig. 3 und 4 gezeigten Ausführungsform eines erfindungsgemäß ausgebildeten Trägers 100 ist es für das sichere Festhalten eines scheibenförmigen Gegenstandes am Träger 100 nicht mehr wesentlich, daß durch eine besondere Ausbildung der ringförmigen Düse 8 beim Ausströmen von Gas aus der ringförmigen Düse 8 zwischen der dem Gegenstand zugekehrten Fläche 9 des Trägers 100 und dem Gegenstand Unterdruck entsteht, der den scheibenförmigen Gegenstand hält. Ein nach dem Bernoulli-Prinzip allenfalls entstehender Unterdruck kann aber das Festhalten des Gegenstandes am erfindungsgemäßen Träger 100 unterstützen.

## Patentansprüche

1. Träger (100) für scheibenförmige Gegenstände, insbesondere für Siliziumscheiben während des Ätzens derselben, mit welchem Träger der scheibenförmige Gegenstand in Drehung versetzt werden kann, mit einer ringförmigen Düse (8) in der dem Gegenstand zugekehrten, vorzugsweise kreisrunden, Fläche (10) des Trägers (100), der Druckgas zugeführt wird, mit mehreren, in der dem Gegenstand zugekehrten Fläche (10) des Trägers (100) vorgesehenen, mit Unterdruck beaufschlagten Öffnungen (107), und mit Injektordüsen (112), die diesen Unterdruck erzeugen, **dadurch gekennzeichnet, daß** von der dem Gegenstand zugekehrten Fläche (10) des Trägers (100) mehrere, zueinander konzentrische, ringförmige Rippen (120) abstehen, die als Auflage für den Gegenstand dienen, daß die ringförmigen Rippen (120) innerhalb der ringförmigen Düse (8) angeordnet sind, daß die mit Unterdruck beaufschlagten Öffnungen (107) innerhalb der radial äußersten und außerhalb der radial innersten ringförmigen Rippe (120) angeordnet sind, daß von jeder mit Unterdruck beaufschlagten Öffnung (107) eine Leitung (110) ausgeht, die jeweils zu einer Injektordüse (112), die im Träger (100) angeordnet ist, führt, und daß die Injektordüsen (112) vom die ringförmige Düse (8) beaufschlagenden Druckgas durchströmt sind.

2. Träger nach Anspruch 1, **dadurch gekennzeichnet, daß** jede ringförmige Rippe (120) mit Ausnahme der äußersten ringförmigen Rippe (120) wenigstens eine Unterbrechung (121) aufweist.

3. Träger nach Anspruch 1 oder 2, **dadurch gekennzeichnet, daß** die mit Unterdruck beaufschlagten Öffnungen (107) auf einem zur Achse des Trägers (100) konzentrischen Kreis angeordnet sind und daß die Unterbrechungen (121) in den ringförmigen Rippen (120) auf von den Öffnungen (107) ausgehenden und bezüglich der Achse des Trägers (100) abwechselnd radial nach innen und nach außen führenden Linien angeordnet sind.

4. Träger nach einem der Ansprüche 1 bis 3, **dadurch gekennzeichnet, daß** der gesamte, innerhalb der ringförmigen Düse (8) liegende Teil (10) der dem Gegenstand zugekehrten Fläche des Trägers (100) mit ringförmigen Rippen (120) versehen ist.

5. Träger nach einem der Ansprüche 1 bis 4, **dadurch gekennzeichnet, daß** die äußerste ringförmige Rippe (120) dem Umfang des die ringförmige Düse (8) radial innen begrenzenden Randes der dem Gegenstand zugekehrten Fläche (10) des Trägers (100) unmittelbar benachbart angeordnet ist.

6. Träger nach einem der Ansprüche 1 bis 5, **dadurch gekennzeichnet, daß** der Abstand der mit Unterdruck beaufschlagten Öffnungen (107) von der Achse des Trägers (100) kleiner ist als der halbe Radius des innerhalb der ringförmigen Düse (8) liegenden Teils (10) der dem Gegenstand zugekehrten Fläche des Trägers (100).

7. Träger nach einem der Ansprüche 1 bis 6, **dadurch gekennzeichnet, daß** die Injektordüsen (112) als Erweiterungen (136) in Strömungskanälen (105) ausgebildet sind, die von einem in der Mitte des Trägers (100) angeordneten Kanal (14) radial nach außen führen.

8. Träger nach Anspruch 7, **dadurch gekennzeichnet, daß** die Leitungen (110) am radial innen liegenden Ende der Erweiterungen (136) der Kanäle (105) vorgesehen sind.

9. Träger nach Anspruch 7 oder 8, **dadurch gekennzeichnet, daß** zwischen jedem eine Injektordüse (112) aufweisenden Kanal (105) wenigstens ein injektordüsenfreier Kanal (105), der sich vom Kanal (14), über den Druckgas zugeführt wird, radial nach außen erstreckt, vorgesehen ist.

10. Träger nach einem der Ansprüche 1 bis 9, **dadurch gekennzeichnet, daß** die Injektordüsen (112) aufweisenden Kanäle (105) und die injektordüsenfreien Kanäle (105) im inneren Teil (103) des Trägers (100) angeordnet sind.

## Claims

1. Support (100) for disc-shaped objects, in particular for silicon discs during etching of the same, by means of which support the disc-shaped object can be set in rotation, having an annular nozzle (8) in the face (10) of the support (100), which face is orientated towards the object and is preferably circular, and to which nozzlepressure gas is supplied, having a plurality of openings (107) which are provided in the face (10) of the support (100) orientated towards the object and are subject to low pressure and having injector-nozzles (112) which produce this low pressure, **characterised**
**in that** a plurality of annular ribs (120), which are concentric to each other, protrude from the face (10) of the support (100), which face is orientated towards the object, said ribs serving as support for the object, in that the annular ribs (120) are disposed internally of the annular nozzle (8), in that the openings (107) which are subject to low pressure are disposed internally of the radially outermost and externally of the radially innermost annular ribs (120), in that a conduit (110) issues from each opening (107) which is subject to low pressure, which conduit respectively leads to an injector nozzle (112), which
is disposed in the support (100), and in that the injector nozzles (112) are subject to pressure gas which charges upon the annular nozzle (8).

2. Support according to claim 1, **characterised in that** each annular rib (120), with the exception of the outermost annular rib (120), has at least one gap (121).

3. Support according to claim 1 or 2, **characterised in that** the openings (107) which are subject to low pressure are disposed on a circle which is concentric to the axis of the support (100), and **in that** the gaps (121) in the annular ribs (120) are disposed on lines which issue from the openings (107) and lead radially inwardly and outwardly alternately with respect to the axis of the support (100).

4. Support according to one of the claims 1 to 3, **characterised in that** the entire portion (10), which is situated internally of the annular nozzle (8), of the face of the support (100), which face is orientated towards the object, is provided with annular ribs (120).

5. Support according to one of the claims 1 to 4, **characterised in that** the outermost annular rib (120) is disposed immediately adjacent to the circumference of the edge of the face (10) of the support (100), which face is orientated towards the object and which edge delimits the annular nozzle (8) radially inwardly.

6. Support according to one of the claims 1 to 5, **characterised in that** the spacing of the openings (107), which are subject to low pressure, from the axis of the support (100) is smaller than the half radius of the portion (10), which is situated internally of the annular nozzle (8), of the face of the support (100) which is orientated towards the object.

7. Support according to one of the claims 1 to 6, **characterised in that** the injector nozzles (112) are configured as extensions (136) in flow channels (105), which lead radially outwardly from a channel which is disposed in the centre of the support (100).

8. Support according to claim 7, **characterised in that** the conduits (110) are provided at the end, which is situated radially inwardly, of the extensions (136) of the channels (105).

9. Support according to claim 7 or 8, **characterised in that** at least one channel (105), which is free of an injection nozzle, is provided between each channel which has an injector nozzle (112), said channel (105) extending radially outwardly from the channel (14) via which the pressure gas is supplied.

10. Support according to one of the claims 1 to 9, **characterised in that** the channels (105) which have injector nozzles (112) and the channels (105) which are free of injector nozzles are disposed in the internal portion (103) of the support (100).

## Revendications

1. Support (100) pour des objets en forme de disques . en particulier pour des disques ; de silicium pendant la gravure de celles-ci, à l'aide duquel l'objet en forme de disque peut être mis en rotation, comportant une buse (8) annulaire aménagée dans la surface (10), de préférence circulaire, du support (100) tournée vers l'objet, qui est alimentée en gaz sous pression, plusieurs ouvertures (107) aménagées dans la surface (10) du support (100) tournée vers l'objet, qui sont soumises à une dépression ainsi que des buses-injecteurs (112) qui génèrent ladite dépression, **caractérisé en ce que** plusieurs nervures (120) annulaires, mutuellement concentriques, qui servent d'appui pour l'objet, s'étendent à partir de la surface (10) du support (100) tournée vers l'objet, **en ce que** les nervures (120) annulaires sont disposées à l'intérieur de la buse (8) annulaire, **en ce que** les ouvertures (107) soumises à une dépression sont disposées à l'intérieur de la nervure annulaire (120) située radialement le plus à l'extérieur et à l'extérieur de la nervure annulaire (120) située radialement le plus à l'intérieur, **en ce que** de chaque ouverture (107) soumise à une dépression part une conduite (110) qui mène chaque fois à une buse-injecteur (112) disposée dans le support (100), et **en ce que** les buses-injecteurs (112 sont traversées par le gaz sous pression qui alimente la buse (8) annulaire.

2. Support selon la revendication 1, **caractérisé en ce que** chaque nervure annulaire (120), à l'exception de la nervure annulaire (120) la plus extérieure, présente une discontinuité (121).

3. Support selon la revendication 1 ou 2, **caractérisé en ce que** les ouvertures (107) soumises à une dépression sont disposées sur un cercle concentrique à l'axe du support (100) et **en ce que** les discontinuités (121) dans les nervures (120) sont disposées sur des lignes qui s'étendent à partir des ouvertures (107) et par rapport à l'axe du support mènent alternativement radialement vers l'intérieur et vers l'extérieur.

4. Support selon une des revendications 1 à 3, **caractérisé en ce que** la totalité de la portion (10) de la surface du support (100) tournée l'objet, située à l'intérieur de la buse annulaire (8), est pourvue de nervures (120) annulaires.

5. Support selon une des revendications 1 à 4, **caractérisé en ce que** la nervure annulaire (120) la plus extérieure est disposée dans le voisinage immédiat du bord de la surface (10) du support (100) tournée vers l'objet, qui délimite la buse (8) annulaire radialement en direction de l'intérieur.

6. Support selon une des revendications 1 à 5, **caractérisé en ce que** la distance par rapport à l'axe du support (100) des ouvertures (107) soumises à une dépression est inférieure au demi rayon de la portion (10) de la surface du support (100) tournée vers l'objet nervure annulaire (120) située à l'intérieur de la buse (8) annulaire.

7. Support selon une des revendications 1 à 6, **caractérisé en ce que** les buses-injecteurs (112) sont réalisées sous la forme d'élargissements (136) dans des canaux d'écoulement (105) qui, depuis un canal (14) au centre du support (100), mènent radialement vers l'extérieur.

8. Support selon la revendication 7, **caractérisé en ce que** les conduites (110) sont prévues à l'extrémité des élargissements (136) des canaux (105).

9. Support selon la revendication 7 ou 8, **caractérisé en ce qu'**il est prévu entre chaque canal (105) pourvu d'une buse-injecteur (112), au moins un canal (105) sans buse-injecteur qui s'étend radialement vers l'extérieur à partir du canal (14) par lequel le gaz sous pression est introduit.

10. Support selon une des revendications 1 à 9, **caractérisé en ce que** les canaux (105) pourvus de buses-injecteurs (112) et les canaux (105) sans buse-injecteur sont disposés dans la portion intérieure (103) du support (100).
